# EUROPÄISCHE PATENTSCHRIFT

(11) **EP 0 980 139 B1**
(45) Veröffentlichungstag und Bekanntmachung des Hinweises auf die Patenterteilung: **17.04.2002**
(21) Anmeldenummer: 99114930.3
(22) Anmeldetag: 30.07.1999
(51) Int. Cl.: H03K 17/14, H03K 17/945, G01S 7/52

(54) **Temperaturkompensiertes elektrisches Gerät und Verfahren zur Temperaturkompensation**
Temperature compensated electrical apparatus and method for temperature compensation
Appareil électrique à température compensée et procédé de compensation de température

(30) Priorität: 12.08.1998 DE 19836611
(43) Veröffentlichungstag der Anmeldung: 16.02.2000
(73) Patentinhaber: SIEMENS AKTIENGESELLSCHAFT, 80333 München (DE)
(72) Erfinder: Luber, Ernst, Dipl.-Ing., 92259 Neukirchen (DE); Neuner, Claudia, 92256 Hahnbach (DE)

(56) Entgegenhaltungen:
- GB-A- 2 153 998
- GB-A- 2 207 759
- US-A- 4 910 717
- US-A- 4 942 765
- US-A- 5 144 593

## Beschreibung

Die Erfindung bezieht sich auf ein temperaturkompensiertes elektrisches Gerät mit einem mit dem Gehäuse wärmegekoppelten Sensor, der zur Weiterleitung und Auswertung seiner Sensorsignale mit der elektrischen Schaltung verbunden ist, die derart ausgeführt ist, daß die Auswertung unter Berücksichtigung der sich ändernden Temperaturwerte der Umgebung des Geräts erfolgt, zu deren Erfassung ein Temperaturfühler vorgesehen ist.

Außerdem bezieht sich die Erfindung auf ein Verfahren zur Temperaturkompensation bei der Ultraschall-Abstandsmessung mit einem Ultraschall-Näherungsschalter unter Berücksichtigung des Einflusses der Temperatur im schallübertragenden Medium.

Ein temperaturkompensiertes, elektrisches Gerät der obengenannten Art ist ein temperaturkompensierter Ultraschall-Näherungsschalter, bei dem die temperaturabhängige Laufzeitmessung mittels einer Temperaturfühlerschaltung von einem Mikrocontroller kompensiert wird. Um eine möglichst fehlerfreie Temperaturerfassung zu erreichen, ist nach bisherigem Kenntnisstand eine Entkopplung von der Erwärmung im Inneren des Ultraschall-Näherungsschalters erforderlich, die durch die Verlustleistung der internen Schaltung erzeugt wird. Hierzu wurde bisher der Temperaturfühler von der Sensorplatine mit der Schaltung und der unmittelbar umgebenen Hülse entfernt angebracht. Diese konstruktiv aufwendige Lösung wird mittels Anbindung des Temperaturfühlers über eine flexible Leiterplatte oder Anschlußleitungen bzw. über einen externen Temperaturfühler erreicht. Aufgrund der fortwährenden Miniaturisierung bei den Sensoren und der Nachfrage nach preisgünstigeren Sensoren wird eine kosten- bzw. platzneutrale Lösung für eine möglichst fehlerfreie Temperaturerfassung gesucht.

Die US-A-4,910,717 offenbart einen Ultraschallnäherungsschalter zur Abstandsmessung mit einer Schaltung und einem gegenüber dieser Schaltung thermisch isolierten Temperaturfühler an der Oberfläche des Ultraschallnäherungsschalters. Aufgrund dieser Temperaturmessung an der Oberfläche und einer zusätzlichen Temperaturmessung im Innenraum des Ultraschallnäherungsschalters wird mittels gewichteter Subtraktion die Außentemperatur des den Näherungsschalter umgebenden Mediums abgeschätzt. Der Einfluß der betriebsbedingten Eigenerwärmung des Ultraschallnäherungsschalters, z.B. in Abhängigkeit von den Einbaubedingungen, von der Versorgungsspannung und des Laststromes, wird hier nicht berücksichtigt.

Der Erfindung liegt die Aufgabe zugrunde, ein temperaturkompensiertes elektrisches Gerät der obengenannten Art zu schaffen, daß bei geringem Hardware- und Kostenaufwand eine möglichst genaue Erfassung der Umgebungstemperatur ermöglicht. Die Lösung soll zu dem platzneutral und für miniaturisierte Geräte geeignet sein.

Außerdem liegt der Erfindung die Aufgabe zugrunde, ein Verfahren zur Temperaturkompensation anzugeben, das geringen Aufwand erfordert.

Die erstgenannte Aufgabe wird mit den Merkmalen nach Anspruch 1 gelöst. Dabei wird dem Erfordernis nach geringem Bauvolumen dadurch Rechnung getragen, daß die genannten Komponenten auf derselben Leiterplatte angeordnet sind. Mit den im Speicher abgespeicherten Temperaturwerten, die den Einfluß der betriebsbedingten Eigenerwärmung im Gerät wiedergeben, läßt sich der mit dem Temperaturfühler erfaßte Temperaturverlauf auf einfache Weise korrigieren.

Eine Weiterbildung der erfinderischen Lösung ist gegeben, wenn das elektrische Gerät als Ultraschall-Näherungsschalter mit einem Ultraschall-Wandler als Sensor ausgeführt ist. Bei einem derartigen Gerät kommt die erfindungsgemäße Lösung wegen der dort vorherrschenden besonderen Anforderungen besonders zum Tragen. Die Echolaufzeitmessung bei einem Ultraschall-Näherungsschalter ist nämlich abhängig von der Tempe ratur des schallübertragenden Mediums. Außerdem zeigt sich hier ein besonderer Trend, die Geräte soweit wie möglich zu verkleinern, so daß man hier in besonderer Weise dem obengenannten Erwärmungsproblem begegnet.

Eine besonders vorteilhafte Weiterbildung der Erfindung besteht, wenn die elektrische Schaltung einen Mikrocontroller mit einem Analog/Digital-Wandler aufweist, der zur Digitalisierung der vom Temperaturfühler erfaßten Temperaturwerte dient. Dies bedeutet, daß bei einer derartigen Ausführung die Digitalisierung ohne zusätzlichen Hardware-Aufwand ausgeführt werden kann.

Vorteilhafterweise ist der Temperaturfühler als NTC-Widerstand ausgeführt, da es sich hierbei um ein bewährtes und kostengünstiges Bauteil für diesen Zweck handelt.

Die weitere Aufgabe wird mit einem Verfahren zur Temperaturkompensation gemäß Anspruch 6 gelöst.

Eine vorteilhafte Weiterbildung des erfindungsgemäßen Verfahrens besteht, wenn Temperaturwerte mehrerer Temperaturverläufe im Näherungsschalter abgespeichert sind, die jeweils den Einfluß der Eigenerwärmung im Näherungsschalter bei spezifischen Betriebsbedingungen, d.h. auch unterschiedlichen Gehäuseausführungen und/oder Montagebedingungen, wiedergeben und einer der Temperaturverläufe mit seinen Temperaturwerten zur Temperaturkompensation auswählbar ist. Damit ist die Möglichkeit einer einfachen Anpassung der Temperaturkompensation an verschiedene Einsatz- bzw. Anwendungsfälle möglich.

Ist einer der Temperaturverläufe durch Parametrierung des Näherungsschalters von außen auswählbar, so kann der in Betriebnehmer unter Berücksichtigung der vorliegenden Geräteausführung bzw. der vorhandenen Montagebedingungen auf einfache Weise den Temperaturverlauf für die Temperaturkompensation vorgeben.

Eine etwas aufwendigere Lösung besteht, wenn die Auswahl einer der Temperaturverläufe zur Temperaturkompensation nach einem Lernmodus erfolgt, bei dem mit dem Temperaturfühler erfaßte Temperaturen mit zeitlich zugehörigen Temperaturen der abgespeicherten Temperaturverläufe verglichen werden. Diese Lösung hat allerdings den Vorzug, daß z.B. keine Vorgabe durch den Inbetriebnehmer erforderlich ist, sondern vielmehr das Gerät von sich aus die am besten geeignete Temperaturkompensation herausfindet und verwendet.

Ein Ausführungsbeispiel der Erfindung wird im folgenden anhand einer Zeichnung näher erläutert. Es zeigen:
- FIG 1: den prinzipiellen Aufbau eines erfindungsgemäßen elektrischen Geräts mit Temperaturkompensation, hier einen Ultraschall-Näherungsschalter mit einer elektrischen Schaltung in einem Gehäuse,
- FIG 2: eine Leiterplatte mit der elektrischen Schaltung gemäß FIG 1,
- FIG 3: drei Temperaturverläufe für unterschiedliche Montagebedingungen des elektrischen Geräts,
- FIG 4: drei Temperaturverläufe für unterschiedliche Geräteausführungen,
- FIG 5: mehrere Temperaturverläufe zur Wiedergabe unterschiedlicher Eigenerwärmung und
- FIG 6: unter Berücksichtigung der Temperaturkompensation ermittelte Meßergebnisse für eine Ultraschall-Abstandsmessung.

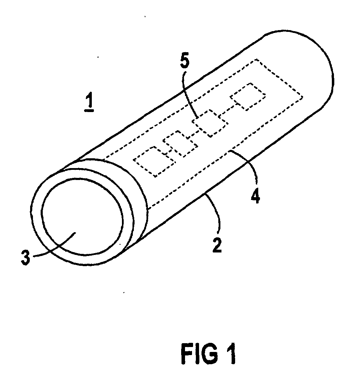

FIG 1 zeigt ein erfindungsgemäßes elektrisches Schaltgerät 1, hier einen Ultraschall-Näherungsschalter, der ein hülsenförmiges Gehäuse 2 aufweist, das an seiner einen Stirnseite mit einem Sensor 3, hier einem Ultraschallwandler, abgeschlossen ist. Im Inneren befindet sich eine Leiterplatte 4 mit einer hier nur angedeuteten elektrischen Schaltung 5.

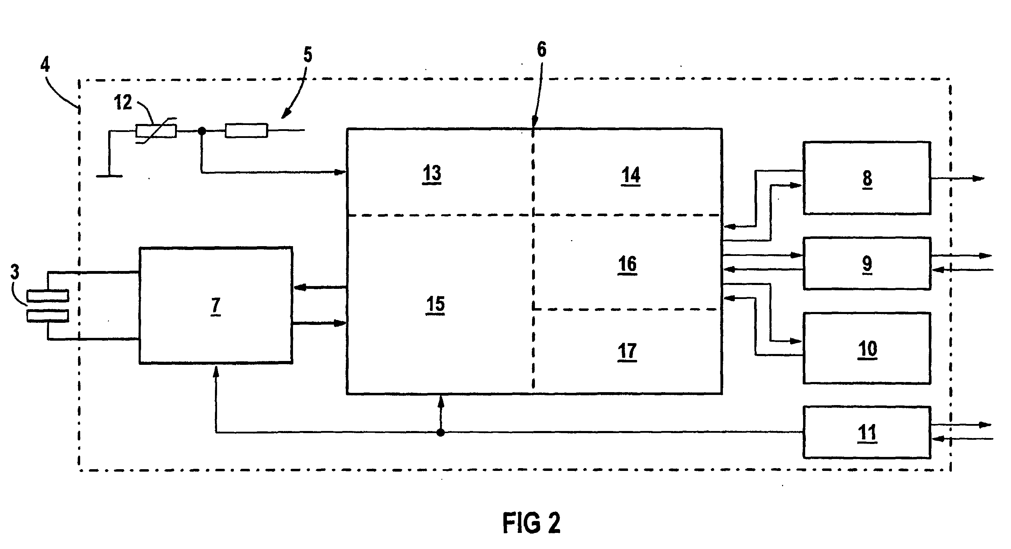

In FIG 2 ist die Leiterplatte 4 mit den wesentlichen Komponenten der Schaltung 5 des Ultraschall-Näherungsschalters 1 dargestellt. Hierzu gehören ein Mikrocontroller 6 sowie ein Sensorteil 7, Ausgangsstufen 8, eine Freigabe-Einheit 9, ein Festwertspeicher 10, eine interne Spannungsversorgung 11, ein Temperaturfühler 12 und der Ultraschallwandler 3. Die letztgenannten Komponenten sind mittelbar oder unmittelbar mit dem Mikrocontroller 5 verbunden, der einen Analog/Digital-Wandler 13, eine Speichereinheit 14 mit ROM- und RAM-Speichern, einen Timer 15, eine Anschlußeinheit 16 mit Ein- und Ausgängen zur Verbindung mit den Ausgangsstufen 8, mit der Freigabe-Einheit 9 und mit dem Festwertspeicher 10 sowie eine Auswerte- und Recheneinheit 17 umfaßt. Der Temperaturfühler 12 ist hier als NTC-Widerstand ausgeführt und mit dem Analog/Digital-Wandler 13 verbunden. Der Ultraschallwandler 3 ist an den Sensorteil 7 gekoppelt, der im wesentlichen einen Sendeoszillator und einen geregelten Filterverstärker enthält und bidirektional mit dem Timer 15 in Verbindung steht.

Der Mikrocontroller 6 übernimmt die wesentlichen Steuerfunktionen. Mit Hilfe des Timers 15 werden zyklisch ein Sendeimpuls und das Freigabesignal für den Sendeoszillator erzeugt sowie die Echolaufzeiten des vom Ultraschall-Näherungsschalter 1 ausgesendeten Ultraschallsignals gemessen. Die Laufzeitmessung ist abhängig von der Temperatur des schallübertragenden Mediums.

Der NTC-Widerstand 12 wird möglichst so plaziert, daß eine gute Kopplung zu der zu erfassenden Umgebungstemperatur, d.h. der Temperatur des schallübertragenden Mediums, erreicht wird.

Nach Einschalten des Ultraschall-Näherungsschalters 1 ergibt sich im Gehäuse 2 eine betriebsbedingte Eigenerwärmung, die hier im wesentlichen durch die Spannungsversorgung 11 hervorgerufen wird. Durch die Nähe zur Spannungsversorgung 11 und die auf der Leiterplatte 4 vorhandenen Wärmebrücken erfaßt der Temperaturfühler 12 einen entsprechenden, durch die Eigenerwärmung bedingten Temperaturverlauf. Abhängig von den im Gehäuse 2 befindlichen Wärmequellen, insbesondere von der jeweils angewendeten Spannungsversorgung 11, und den jeweils vorliegenden Montagebedingungen, durch die mehr oder weniger Wärmeenergie über das Gehäuse 2 abgeführt wird, können sich unterschiedliche, vom Temperaturfühler 12 erfaßbare Temperaturverläufe ergeben.

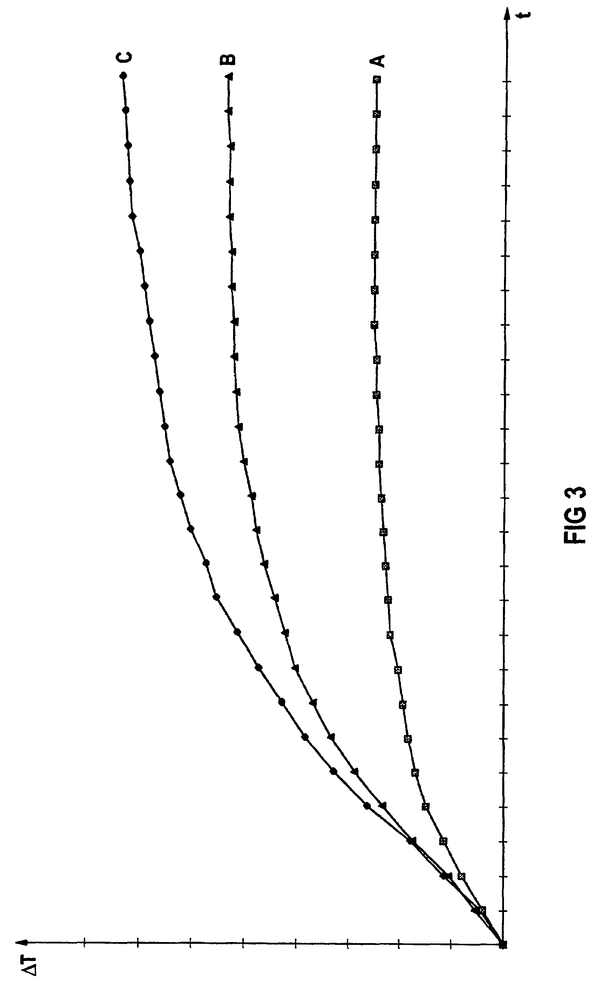

Im Diagramm gemäß FIG 3 ist der Einfluß unterschiedlicher Montagebedingungen auf den Temperaturverlauf dargestellt, wobei auf der Abszisse die Meßdauer t ab Einschaltung eines Ultraschall-Näherungsschalters dargestellt ist und auf der Ordinate die Temperaturänderung ΔT. Die dargestellten mit dem Temperaturfühler 12 erfaßten Temperaturverläufe gelten für unterschiedliche Montagebedingungen:
- Kurve A: bei Montage des Gehäuses 2 auf einer dicken Eisenplatte,
- Kurve B: bei Montage auf einem Eisenwinkel und
- Kurve C: bei Montage mittels einer Kunststoffschelle.

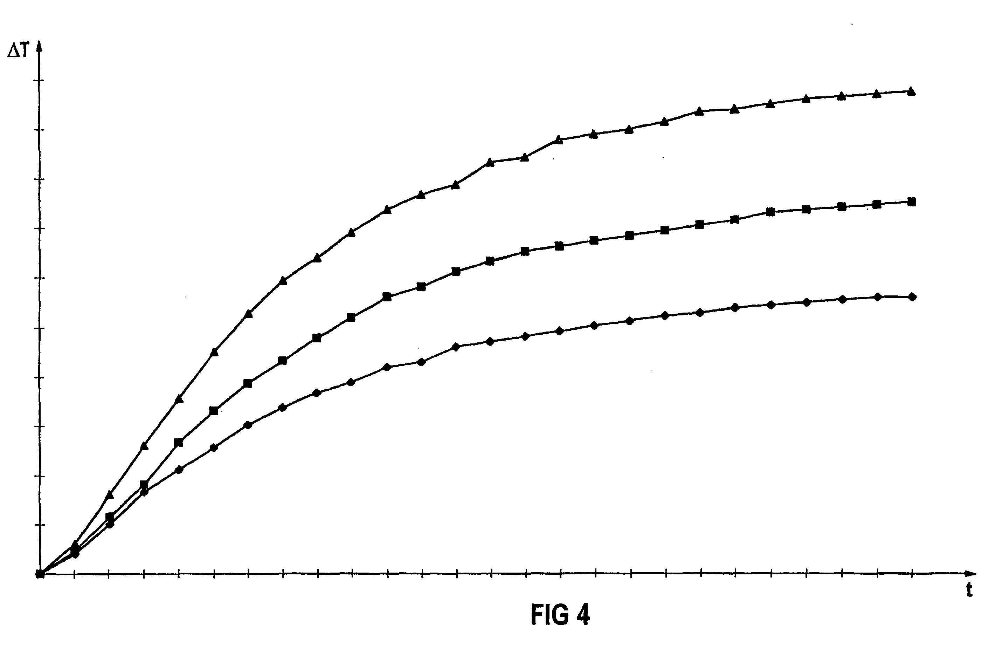

Die Temperaturwerte sind für äquidistante Zeitintervalle bei ansonsten gleichen Bedingungen angegeben, d.h. bei konstanter Umgebungstemperatur für einen bestimmten Ultraschall-Näherungsschalter. Im Diagramm gemäß FIG 4 ist der Einfluß unterschiedlicher Wärmequellen, hier unterschiedlicher Spannungsversorgungen 11, bei ansonsten gleichem Ultraschall-Näherungsschalter und stets gleicher Montageart dargestellt. Die oberste Kurve im Diagramm, d.h. die höchste Temperaturänderung für die auf der Abszisse aufgetragene Meßdauer t ergibt sich für die Spannungsversorgung mit den höchsten Verlusten.

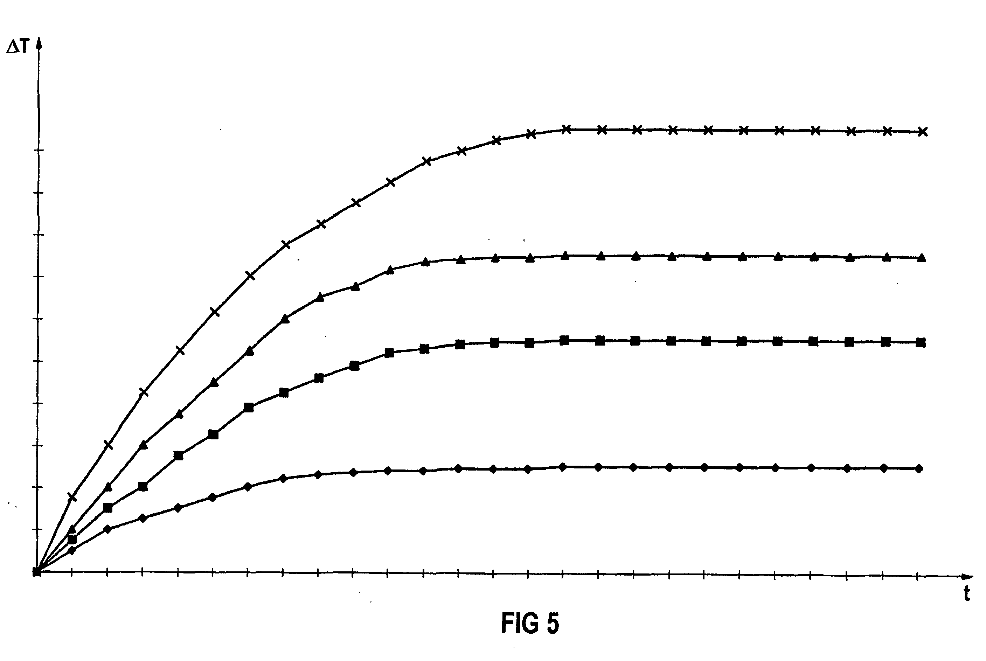

Für den Ultraschall-Näherungsschalter 1 lassen sich demzufolge unterschiedliche Temperaturverläufe ermitteln und angeben, die den Bereich möglicher Temperaturänderungen für die in Frage kommenden Geräteausführungen und Montagebedingungen annähernd abdecken. Derartige Temperaturverläufe, wie sie in FIG 4 und 5 dargestellt sind, werden im erfindungsgemäßen Gerät 1 abgespeichert und dienen zur Korrektur der mit dem Temperaturfühler 12 erfaßten Temperaturwerte. Beim Ultraschall-Näherungsschalter 1 mit dem Mikrocontroller 5 erfolgt die Abspeicherung zweckmäßigerweise in der bereits verfügbaren Speichereinheit 14.

Gemäß dem erfindungsgemäßen Verfahren zur Temperaturkompensation bei der Ultraschall-Abstandsmessung mit einem Ultraschall-Näherungsschalter 1 werden die durch den Temperaturfühler 12, d.h. hier über den NTC-Widerstand erfaßten Temperaturwerte, nach Einschaltung des Geräts 1 an den Analog/Digital-Wandler 13 des Mikrocontrollers 5 weitergeleitet und nach der dortigen Digitalisierung in äquidistanten Zeitabständen abgespeichert. Diese digitalisierten Temperaturwerte werden bei der Laufzeit-Auswertung zur Ermittlung des Meßabstands in der Auswerte- und Recheneinheit 17 verarbeitet, wobei die vom Temperaturfühler 12 gemessenen Temperaturwerte mit Temperaturwerten von einer der abgespeicherten Temperaturverläufe korrigiert werden, um den Einfluß der Eigenerwärmung auszuschalten. Für die Auswahl des am besten geeigneten Temperaturverlaufs zur Temperaturkompensation sind zwei Möglichkeiten vorgesehen. Sofern der Inbetriebnehmer die Zuordnung zu dem richtigen Temperaturverlauf aufgrund der ihm bekannten Geräteausführung und der vorliegenden Montagebedingungen selbst vornehmen kann, ist eine entsprechende Zuordnung durch Parametrierung des Ultraschall-Näherungsschalters von außen her möglich. Andernfalls ist vorgesehen, daß bei der Inbetriebnahme zunächst ein Lernmodus abläuft, nach dem die erfaßten und anschließend digitalisierten Temperaturwerte mit zeitlich entsprechenden Temperaturwerten der abgespeicherten Temperaturverläufe gemäß FIG 5 verglichen werden, was mit Hilfe eines entsprechenden Auswertealgorithmus in der Auswertungs- und Recheneinheit 17 erfolgt. Aufgrund dieses Vergleichs wird die am nächsten der Eigenerwärmung nahekommende Kurve der Temperaturverläufe, z.B. gemäß FIG 5, zum Abschluß des Lernmodus festgehalten und für den weiteren Betrieb bei der Auswertung der Ultraschall-Laufzeit zur Ermittlung des Abstands herangezogen.

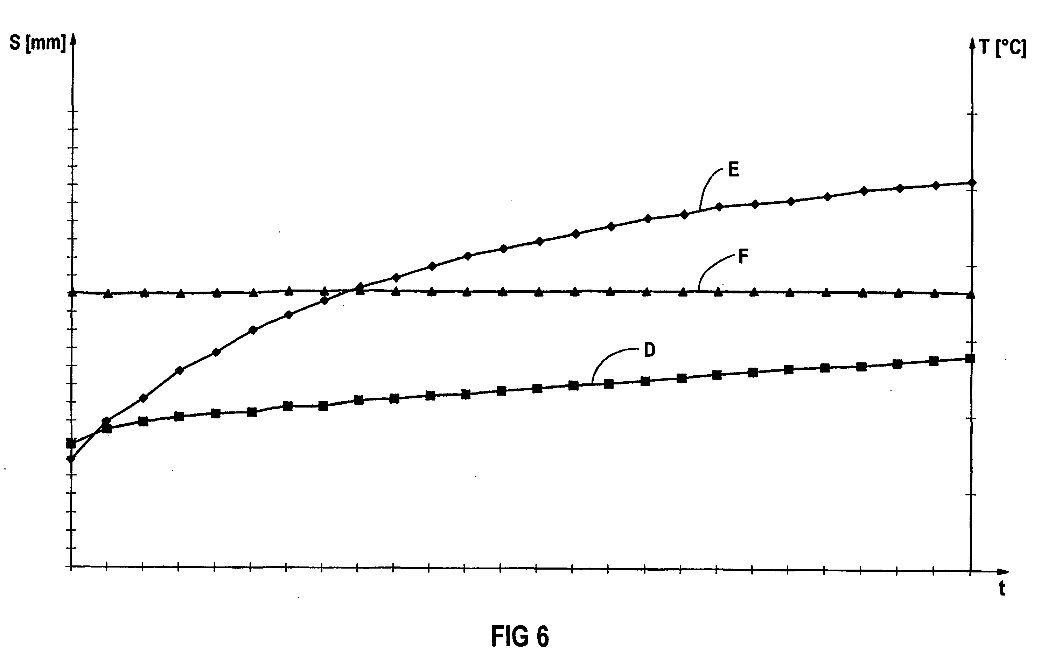

In FIG 6 ist dargestellt, daß aufgrund der Temperaturkompensation trotz der betriebsbedingten Eigenerwärmung bei nahezu konstanter Umgebungstemperatur die ermittelte Abstandswerte konstant bleiben. Auf der Abszisse ist wiederum die Meßdauer t aufgetragen. Die linke Ordinate gibt den Meßabstand s und die rechte Ordinate die Temperatur T wieder. Kurve D zeigt den zeitlichen Verlauf der Umgebungstemperatur und die Kurve E den im Näherungsschalter 1 mit dem Temperaturfühler 12 erfaßten Temperaturverlauf an. Trotz der starken Eigenerwärmung ergeben sich für den ermittelten Meßabstand s aufgrund der Temperaturkompensation nahezu konstante Werte gemäß Kurve F.

## Patentansprüche

1. Temperaturkompensiertes, elektrisches Gerät (1) mit einem Gehäuse (2), in dem eine elektrische Schaltung (5) angeordnet ist, und mit einem mit dem Gehäuse (2) wärmegekoppelten Sensor (3), der zur Weiterleitung und Auswertung seiner Sensorsignale mit der elektrischen Schaltung (5) verbunden ist, die derart ausgeführt ist, daß die Auswertung unter Berücksichtigung der sich ändernden Temperaturwerte der Umgebung des Geräts (1) erfolgt, zu deren Erfassung ein Temperaturfühler (12) vorgesehen ist, **dadurch gekennzeichnet, daß** der Temperaturfühler (12) und die elektrische Schaltung (5) auf derselben Leiterplatte (4) im Gehäuse (2) angeordnet sind, daß der Temperaturfühler (12) zur Erfassung des zeitlichen Temperaturverlaufs dient, der sich aus der Umgebungstemperatur des Geräts (1) und der betriebsbedingten Eigenerwärmung, z.B. abhängig von Montagebedingungen und/oder von der Spannungsversorgung, ergibt und daß die elektrische Schaltung (5) einen Speicher (14) aufweist, in dem Temperaturwerte mindestens eines den Einfluß der betriebsbedingten Eigenerwärmung im Gerät (1) wiedergebenden Temperaturverlaufs abgespeichert sind, die zur Korrektur der mit dem Temperaturfühler (12) erfaßten Temperaturwerte dienen, um die Umgebungstemperatur des Geräts (1) möglichst genau zu erfassen.

2. Elektrisches Gerät nach Anspruch 1,
**dadurch gekennzeichnet, daß** es als Ultraschall-Näherungsschalter (1) mit einem Ultraschallwandler (3) als Sensor ausgeführt ist.

3. Elektrisches Gerät nach Anspruch 1 oder 2,
**dadurch gekennzeichnet, daß** die Umgebungstemperatur des Geräts die Temperatur des umgebenden Mediums ist, in dem sich die Ultraschallwellen ausbreiten.

4. Elektrisches Gerät nach Anspruch 1 oder 2,
**dadurch gekennzeichnet, daß** die elektrische Schaltung einen Mikrocontroller (6) mit einem Analog/Digital-Wandler (13) aufweist, der zur Digitalisierung der vom Temperaturfühler (12) erfaßten Temperaturwerte dient.

5. Elektrisches Gerät nach einem der vorangehenden Ansprüche,
**dadurch gekennzeichnet, daß** der Temperaturfühler als NTC-Widerstand (12) ausgeführt ist.

6. Verfahren zur Temperaturkompensation bei der Ultraschall-Abstandsmessung mit einem Ultraschall-Näherungsschalter (1) unter Berücksichtigung des Einflusses der Temperatur im schallübertragenden Medium,
**dadurch gekennzeichnet, daß**
a) mittels eines Temperaturfühlers (12) im Näherungsschalter (1) im Betrieb der zeitliche Verlauf der sich unter Einfluß der betriebsbedingten Eigenerwärmung im Näherungsschalter (1) ergebenden Temperatur erfaßt wird, wobei die betriebsbedingte Eigenerwärmung z.B. von Montagebedingungen und/oder von der Spannungsversorgung abhängt, und
b) aus dem mit dem Temperaturfühler erfaßten zeitlichen Temperaturverlauf durch Korrektur mit einem im Näherungsschalter abgespeicherten Temperaturverlauf, der den Einfluß der betriebbedingten Eigenerwärmung im Gerät wiedergibt, die Temperatur des den Näherungsschalter umgebenden Mediums ermittelt wird, von der die Laufzeit der Ultraschallwellen abhängt.

7. Verfahren nach Anspruch 6, **dadurch gekennzeichnet, daß** Temperaturwerte mehrerer Temperaturverläufe im Näherungsschalter (1) abgespeichert sind, die jeweils den Einfluß der Eigenerwärmung im Näherungsschalter (1) bei spezifischen Betriebsbedingungen, d.h. auch unterschiedlichen Geräteausführungen und/oder Montagebedingungen, wiedergeben, und einer der Temperaturverläufe mit seinen Temperaturwerten zur Temperaturkompensation auswählbar ist.

8. Verfahren nach Anspruch 7, **dadurch gekennzeichnet, daß** einer der Temperaturverläufe durch Parametrierung des Näherungsschalters (1) von außen auswählbar ist.

9. Verfahren nach Anspruch 7, **dadurch gekennzeichnet, daß** die Auswahl einer der Temperaturverläufe zur Temperaturkompensation nach einem Lernmodus erfolgt, bei dem mit dem Temperaturfühler (12) erfaßte Temperaturen mit zeitlich zugehörigen Temperaturen der abgespeicherten Temperaturverläufe verglichen werden.

## Claims

1. Temperature-compensated electrical device (1) with a housing (2) in which an electrical circuit (5) is located, and with a sensor (3) which is heat-coupled to the housing (2) and which for the purposes of forwarding and evaluation of its sensor signals is connected to the electrical circuit (5) which is designed such that the evaluation is performed whilst taking into consideration the changing temperature values of the environment in which the device (1) is situated, where a temperature sensor (12) is provided for registering such changing temperature values,
**characterised in that** the temperature sensor (12) and the electrical circuit (5) are located on the same printed circuit board (4) in the housing (2), that the temperature sensor (12) is used for sensing the temperature timing characteristic which results from the ambient temperature of the device (1) and the self-warming caused by operation, e.g. depending on mounting conditions and/or the voltage supply, and that the electrical circuit (5) has a memory (14) in which temperature values of at least one temperature characteristic reflecting the influence of the self-warming caused by operation in the device (1) are stored, which temperature values are used for correction of the temperature values sensed by means of the temperature sensor (12) in order to sense the ambient temperature of the device (1) as precisely as possible.

2. Electrical device according to Claim 1,
**characterised in that** takes the form of an ultrasonic proximity switch (1) with an ultrasonic transducer (3) as the sensor.

3. Electrical device according to Claim 1 or 2,
**characterised in that** the ambient temperature of the device is the temperature of the surrounding medium in which the ultrasonic waves are propagated.

4. Electrical device according to Claim 1 or 2,
**characterised in that** the electrical circuit has a micro-controller (6) with an analogue/digital converter (13) which serves to digitise the temperature values sensed by the temperature sensor (12).

5. Electrical device according to one of the preceding claims,
**characterised in that** the temperature sensor takes the form of an NTC resistor (12).

6. Method for temperature compensation in the case of ultrasonic distance measurement with an ultrasonic proximity switch (1) whilst taking into consideration the influence of the temperature in the sound-transmitting medium,
**characterised in that**
a) the timing characteristic of the temperature resulting under the influence of the self-warming caused by operation in the proximity switch (1) is sensed by means of a temperature sensor (12) in the proximity switch (1), whereby the self-warming caused by operation depends e.g. on mounting conditions and/or the voltage supply, and
b) the temperature of the medium surrounding the proximity switch, upon which temperature the propagation time of the ultrasonic waves depends, is determined from the temperature timing characteristic sensed by means of the temperature sensor through correction using a temperature characteristic stored in the proximity switch which reflects the influence of the self-warming caused by operation in the device.

7. Method according to Claim 6, **characterised in that** temperature values from a number of temperature characteristics are stored in the proximity switch (1), which each reflect the influence of the self-warming in the proximity switch (1) under specific operating conditions, i.e. also in the case of different device designs and/or mounting conditions, and one of the temperature characteristics with its temperature values can be selected for the purpose of temperature compensation.

8. Method according to Claim 7, **characterised in that** one of the temperature characteristics can be selected externally by means of parameterisation of the proximity switch (1).

9. Method according to Claim 7, **characterised in that** the selection of one of the temperature characteristics for the temperature compensation is performed on the basis of a learning mode in which temperatures sensed by means of the temperature sensor (12) are compared with temporally associated temperatures for the stored temperature characteristics.

## Revendications

1. Appareil (1) électrique à compensation de la température, comprenant un boîtier (2) dans lequel est disposé un circuit (5) électrique et un capteur (3), qui est couplé calorifiquement au boîtier (2) et qui, pour le réacheminement et l'exploitation de ses signaux de capteur, est relié au circuit (5) électrique, lequel est réalisé de sorte que l'exploitation s'effectue en tenant compte des valeurs de la température ambiante autour de l'appareil (1) et qui se modifient et pour le relevé desquelles il est prévu une sonde (12) de température, **caractérisé en ce que** la sonde (12) de température et le circuit (5) électrique sont montés dans le boîtier (2) sur la même plaquette (4) à circuit imprimé, **en ce que** la sonde (12) de température sert à relever la courbe de la température en fonction du temps qui résulte de la température ambiante autour de l'appareil (1) et du réchauffement propre du au fonctionnement, par exemple en fonction des conditions de montage et/ou de l'alimentation en tension, et **en ce que** le circuit (5) électrique a une mémoire (14) dans laquelle sont mémorisées des valeurs de température d'au moins une courbe de température reproduisant l'influence dans l'appareil (1) du réchauffement propre du au fonctionnement, valeurs qui servent à corriger les valeurs de température relevées par la sonde (12) de température, pour appréhender d'une manière aussi précise que possible la température ambiante autour de l'appareil (1).

2. Appareil électrique suivant la revendication 1, **caractérisé en ce qu'**il est réalisé en interrupteur (1) de proximité à ultrasons ayant un transducteur (3) à ultrasons en tant que capteur.

3. Appareil électrique suivant la revendication 1 ou 2, **caractérisé en ce que** la température ambiante autour de l'appareil est la température du fluide ambiant dans lequel se propagent les ondes ultrasonores.

4. Appareil électrique suivant la revendication 1 ou 2, **caractérisé en ce que** le circuit électrique comporte un microcontrôleur (6) à conversion (13) analogique/numérique qui sert à numériser les valeurs de température relevées par la sonde (12) de température.

5. Appareil électrique suivant l'une des revendications précédentes,
**caractérisé en ce que** la sonde de température est réalisée sous la forme d'une résistance (12) à coefficient négatif de température.

6. Procédé de compensation de l'effet de la température lors de la mesure de distances par ultrasons à l'aide d'un interrupteur (1) de proximité à ultrasons en tenant compte de l'influence de la température dans le fluide de transmission du son,
**caractérisé en ce que**
a) on relève au moyen d'une sonde (12) de température dans l'interrupteur (1) de proximité en fonctionnement, la courbe en fonction du temps de la température résultant de l'influence du réchauffement propre du au fonctionnement de l'interrupteur (1) de proximité, le réchauffement propre du au fonctionnement dépendant par exemple des conditions de montage et/ou de l'alimentation en tension et
b) à partir de la courbe de température en fonction du temps relevée par la sonde de température on détermine, en corrigeant par une courbe de température mémorisée dans l'interrupteur de proximité et reproduisant l'influence dans l'appareil du réchauffement propre du au fonctionnement, la température du fluide ambiant entourant l'interrupteur de proximité, de laquelle dépend le temps de propagation des ondes ultrasonores.

7. Procédé suivant la revendication 6, **caractérisé en ce que** l'on mémorise les valeurs de température de plusieurs courbes de température de l'interrupteur (1) de proximité qui reproduisent respectivement l'influence du réchauffement propre de l'interrupteur (1) de proximité dans des conditions de fonctionnement spécifique, c'est à dire également pour des différences de mode de réalisation de l'appareil et/ou des conditions de montage et l'on peut choisir l'une des courbes de température avec ses valeurs de température pour la compensation de l'effet de la température.

8. Procédé suivant la revendication 7, **caractérisé en ce que** l'on peut choisir l'une des courbes de température en paramétrant l'interrupteur (1) de proximité de l'extérieur.

9. Procédé suivant la revendication 7, **caractérisé en ce que** l'on effectue le choix de l'une des courbes de température pour la compensation de l'effet de la température suivant un mode d'apprentissage, dans lequel on compare les températures relevées par la sonde (12) de température à des températures associées dans le temps des courbes de température mémorisées.
